# EUROPÄISCHE PATENTSCHRIFT

(11) **EP 3 136 751 B1**
(45) Veröffentlichungstag und Bekanntmachung des Hinweises auf die Patenterteilung: **12.04.2023**
(21) Anmeldenummer: 16184069.9
(22) Anmeldetag: 12.08.2016
(51) Int. Cl.: H04R 17/00, H04R 3/00, H04R 19/00

(54) **MEMS-LAUTSPRECHER MIT POSITIONSSENSOR**
MEMS LOUDSPEAKER WITH POSITION SENSOR
HAUT-PARLEUR MEMS AVEC CAPTEUR DE POSITION

(30) Priorität: 27.08.2015 DE 102015114242
(43) Veröffentlichungstag der Anmeldung: 01.03.2017
(73) Patentinhaber: Usound GmbH, 8020 Graz (AT)
(72) Erfinder: RUSCONI CLERICI BELTRAMI, Andrea, 1130 Wien (DE); BOTTONI, Ferruccio, 8020 Graz (AT)
(74) Vertreter: Canzler & Bergmeier Patentanwälte Partnerschaft mbB

(56) Entgegenhaltungen:
- EP-A2- 1 051 058
- DE-A1-102011 086 722
- JP-A- S59 139 799
- US-A1- 2005 130 360
- US-A1- 2011 051 985
- US-A1- 2011 182 150
- US-A1- 2012 087 521
- US-A1- 2014 177 881
- US-A1- 2015 071 467

## Beschreibung

Die vorliegende Erfindung betrifft einen MEMS-Lautsprecher zum Erzeugen von Schallwellen im hörbaren Wellenlängenspektrum mit einer Leiterplatte, einer gegenüber der Leiterplatte entlang einer z-Achse auslenkbaren Membran, zumindest einem piezoelektrischen Aktuator zum Auslenken der Membran und einer vollständig in der Leiterplatte eingebetteten elektronischen Steuereinheit zum Ansteuern des Aktuators, insbesondere einem ASIC.

Die Bezeichnung MEMS steht für mikroelektromechanische Systeme. Derartige Systeme werden besonders in elektronischen Geräten verbaut, die nur wenig Bauraum bieten. Die Performance bekannter MEMS-Lautsprecher ist größtenteils von idealen Umgebungsbedingungen abhängig. Schon kleine Schläge oder andere Umwelteinflüsse können sich dabei nachteilig auf die Leistungsfähigkeit des Systems auswirken. Die heutigen Anforderungen an derartige MEMS-Lautsprecher verlangen jedoch auch bei äußeren Einflüssen eine zumindest gleichbleibende Klangqualität.

Aus der US 2014/0177881 A1, US 2015/0071467 A1, US 2012/0087521 A1, DE 10 2011 086 722 A1, US 2011/0182150 A1, US 2011/0051985 A1, JP S59139799 A, US 2005/0130360 A1 und EP 1 051 058 A2 sind unterschiedliche mikroelektromechanische Systeme bekannt, die den technologischen Hintergrund zu der vorliegenden Erfindung bilden.

Aufgabe der vorliegenden Erfindung ist es somit, einen MEMS-Lautsprecher mit verbesserter Leistungsfähigkeit auszubilden.

Die Aufgabe wird gelöst durch einen MEMS-Lautsprecher mit den Merkmalen des unabhängigen Patentanspruchs 1.

Vorgeschlagen wird ein MEMS-Lautsprecher zum Erzeugen von Schallwellen im hörbaren Wellenlängenspektrum. Der MEMS-Lautsprecher weist eine Leiterplatte, eine Membran, zumindest einen piezoelektrischen Aktuator und eine elektronische Steuereinheit auf. Die Membran ist gegenüber der Leiterplatte entlang einer z-Achse auslenkbar. Der piezoelektrische Aktuator lenkt die Membran aus. Die elektronische Steuereinheit ist vollständig in die Leiterplatte eingebettet und steuert den Aktuator, insbesondere den ASIC, an. Der MEMS-Lautsprecher weist zumindest einen Positionssensor auf. Mittels des Positionssensors ist der Steuereinheit ein von der Membranauslenkung abhängiges Sensorsignal bereitstellbar. Die Steuereinheit ist ausgebildet, um den Aktuator basierend auf dem Steuersignal geregelt anzusteuern.

Hierfür wird die Membran gegenüber dem Aktuator ausgelenkt und/oder deren Position bzw. Auslenkung in z-Richtung mittels des Positionssensors erfasst. Das von dem Positionssensor erfasste elektronische Eingangssignal wird an die Steuereinheit übermittelt. Die Steuereinheit bestimmt anhand dieses Eingangssignals die Ist-Position bzw. Ist-Auslenkung der Membran. In Abhängigkeit dieser erfassten Ist-Position der Membran bestimmt die Steuereinheit eine gewünschte Soll-Position der Membran und/oder ein davon abhängiges elektronisches Ausgangssignal. Das Ausgangssignal wird an den piezoelektrischen Aktuator übermittelt, der die Membran entsprechend auslenkt. Während und/oder am Ende der Auslenkbewegung wird über den Positionssensor erneut die tatsächliche Ist-Position der Membran erfasst und gegebenenfalls gemäß der vorangegangenen Beschreibung erneut und/oder iterativ nachgeregelt bzw. eingeregelt. Äußere Einflüsse und Alterungseffekte können auf diese Weise elektronisch kompensiert werden.

Ein Auslenkungshoch oder ein Wechsel der Resonanzfrequenz, insbesondere bedingt durch äußere Einflüsse, kann mit Hilfe des Positionssensors frühzeitig detektiert und unterdrückt werden. Das Risiko einer Beschädigung der empfindlichen mechanischen und akustischen Bauteile wird dadurch reduziert und somit einem frühzeitigen Verschleiß vorgebeugt. Neben der Lebensdauer wird zudem die Zuverlässigkeit verbessert, da das System individuell auf unterschiedliche Einflüsse reagieren kann. Bei bekannten Systemen sind beispielsweise Hochpassfilter notwendig, um auch bei niedrigen Frequenzen ohne Beschädigung der Bauteile die maximale Lautstärke zu erzeugen. Beim erfindungsgemäßen System kann das Signal derart verstärkt werden, dass die sich störend auswirkende Umgebungsbedingungen ausgeglichen werden.

Durch die geregelte Ansteuerung des Aktuators, basierend auf dem vom Positionssensor ermittelten Signal, kann das System eine Selbstdiagnose durchführen. Die Funktionsfähigkeit des MEMS-Lautsprechers, insbesondere seiner elektromechanischen Bauteile kann dabei ohne zusätzliche Maßnahmen allein durch Abweichungen von definierten Standardwerten ermittelt werden. Die Steuereinheit kann Stöße, Probleme beim Hochfahren oder Leistungseinbußen anhand des Sensorsignales erfassen und individuell, insbesondere durch eine geregelte Ansteuerung des Aktuators, darauf reagieren.

Durch die geregelte Ansteuerung des Aktuators, infolge eines vom Positionssensor bereitgestelltem Signals, können vorteilhafterweise Verzerrungen des MEMS-Lautsprechers reduziert werden. Der Positionssensor ermittelt nichtlineare Schwingungen des piezoelektrischen Aktuators und somit auch der Membran, sodass die Auslenkung des Aktuators an die Umgebungsbedingungen angepasst werden kann, um die harmonische Verzerrung zu minimieren. Zudem kann der MEMS-Lautsprecher an unterschiedliche Umgebungsbedingungen, wie extreme Temperaturen, Druck, Luftfeuchtigkeit, etc. angepasst werden.

Vorteilhaft ist es, wenn die Steuereinheit, der zumindest eine piezoelektrische Aktuator und der zumindest eine Positionssensor einen Regelkreis bilden. Durch äußere Einflüsse bedingte Zustände, wie eine maximale Auslenkung oder ein Wechsel der Resonanzfrequenz können auf diese Weise ermittelt und unterdrückt werden. Auf diese Weise kann der Beschädigung von mechanischen oder akustischen Bauteilen vorgebeugt werden. Zudem kann die Funktionsfähigkeit der elektrischen und mechanischen Komponenten des Systems durch die Ausbildung diesen geschlossenen Regelkreises einfach überprüft werden.

Um die Auslenkung möglichst wenig zu behindern, ist der insbesondere piezoelektrische Aktuator als Kragarm ausgebildet. Alternativ oder zusätzlich ist es von Vorteil, wenn der Positionssensor ein piezoelektrischer, ein piezoresistiver und/oder ein kapazitiver Sensor ist. Die Aktuatorstruktur kann über die Steuereinheit, insbesondere den ASIC, derart angeregt werden, dass die Membran zur Erzeugung von Schallenergie in Schwingung versetzt wird. Der piezoelektrische Positionssensor erfasst sodann die durch die Auslenkung der Membran entstehende Spannungsänderung, welcher wiederum von der Steuereinheit ausgewertet wird. Bei einem piezoresistiven Positionssensor wird hingehen eine Widerstandänderung aufgezeichnet, von welcher ausgehen die Steuereinheit Rückschlüsse auf die Position der Membran ziehen kann. Ein kapazitiver Sensor umfasst hingegen einen feste und eine bewegliche Fläche, die infolge der Anregung der Membran ebenso ausgelenkt wird. Die Abstandänderung der beiden Flächen zueinander bewirkt auch eine Kapazitätsänderung, die wiederum von der Steuereinheit erfasst wird. Je nach Ausbildung des MEMS-Lautsprechers kann sodann ein für das Einsatzgebiet idealer Sensor ausgewählt werden.

Der Positionssensor ist zumindest teilweise in dem Aktuator, nämlich dem Kragarm, integriert. Der zusätzliche Platzbedarf von Sensor-und Verbindungselementen kann auf diese Weise möglichst gering gehalten werden, so dass nur mit geringen Verlusten an Aktuator-Performance zu rechnen ist. Ebenso ist es von Vorteil, wenn der piezoelektrische Positionssensor und der piezoelektrische Aktuator durch eine gemeinsame piezoelektrische Schicht ausgebildet sind. Die piezoelektrische Schicht ist dabei aus Blei-Zirkonat-Titanat (PZT) gefertigt. Die über den piezoelektrischen Effekt generierte Spannung kann zur Auswertung an die Steuereinrichtung übermittelt werden, so dass die IST-Position der Membran in einfacher Art und Weise ermittelt werden kann.

Vorteilhaft ist es, wenn die gemeinsame piezoelektrische Schicht zumindest einen Sensorbereich und zumindest einen Aktuatorbereich aufweist. Der Aktuatorbereich ist dabei von dem Sensorbereich isoliert. Alternativ oder zusätzlich ist der Aktuatorbereich flächenmäßig größer als der Sensorbereich. Auf diese Weise können unterschiedliche Geometrien ausgebildet werden, um die verschiedenen Bereiche und Vibrationsmodi möglichst effizient zu kontrollieren.

Ebenso ist es vorteilhaft, wenn der Sensorbereich, insbesondere symmetrisch und/oder sich in Kragarmlängsrichtung erstreckend, zwischen zwei Aktuatorbereichen angeordnet ist. Die Geometrie der Sensorik kann somit in einfacher Art und Weise an unterschiedliche Anforderungen angepasst werden. Dies erfolgt insbesondere derart, dass die beiden Aktuatorbereiche durch den Sensorbereich vollständig voneinander getrennt sind. Denkbar wäre es auch, mehrere Sensorbereiche auszubilden, die jeweils zwischen zwei Aktuatorbereichen angeordnet sind. Alternativ oder zusätzlich weisen die Sensorbereiche und der Aktuatorbereich in Balkenlängsrichtung die gleiche Länge auf, so dass einer ungewollten Verkippung vorgebeut werden kann.

In einer vorteilhaften Weiterbildung der Erfindung ist der piezoelektrische Positionssensor durch eine erste piezoelektrische Schicht ausgebildet. Dabei hat sich die Verwendung des Werkstoffs Aluminiumnitrid (AIN) wegen seiner hohen Wärmeleitfähigkeit sowie elektrischen Isolationsfähigkeit als vorteilhaft erwiesen. Alternativ oder zusätzlich ist der piezoelektrische Aktuator durch eine zweite piezoelektrische Schicht ausgebildet, wobei diese Schicht insbesondere aus PZT ausgebildet ist. Durch PZT-Piezokeramik-Aktoren kann aufgrund der hohen Energiedichte ein gefordertes Produkt aus Kraft und Weg durch ein vergleichsweise kleines Volumen des Piezoaktuators erreicht werden. Die beiden piezoelektrischen Schichten sind vorzugsweise voneinander elektrisch isoliert. Alternativ oder zusätzlich sind die erste und zweite piezoelektrische Schicht in Bezug zur z-Achse übereinander angeordnet. Der Positionssensor kann somit im Zuge des Herstellungsverfahrens einfach und kostengünstig, insbesondere schichtweise, integriert werden.

Des Weiteren ist es vorteilhaft, wenn die erste piezoelektrische Schicht in mehrere Sensorbereiche unterteilt ist. Die Sensorbereiche sind dabei voneinander getrennt. Die Geometrie des Positionssensors kann somit kostengünstig an unterschiedliche Anwendungen angepasst werden. Alternativ oder zusätzlich sind die Sensorbereiche elektrisch isoliert. Alternativ oder zusätzlich weist die zweite piezoelektrische Schicht einen einzigen Aktuatorbereich auf. Alternativ oder zusätzlich erstreckt sich der Aktuatorbereich in einer Draufsicht vollflächig über den Kragarm. Der piezoelektrische Aktuator kann kostengünstig und flexibel an unterschiedliche Bereiche und Vibrationsmodi angepasst werden.

Vorteilhafterweise sind die, insbesondere drei, Sensorbereiche in Kragarmrichtung voneinander beabstandet angeordnet. Die Beabstandung der Sensorbereiche ist dabei äquidistant. Durch die einheitliche Verteilung der Sensorbereiche kann ein großer Bereich kontrolliert und ermittelte äußere Einflüsse zuverlässig ausgeglichen werden, so dass eine gleichbleibende Klangqualität sichergestellt ist. Alternativ oder zusätzlich weisen die Sensorbereiche zueinander die gleiche Länge aus. Alternativ oder zusätzlich weisen die Sensorbereiche zum Aktuatorbereich in Kragarmlängsrichtung die gleiche Länge auf.

Von Vorteil ist es, wenn der piezoresistive Positionssensor durch zumindest eine Stromleitung ausgebildet ist. Die Stromleitung erstreckt sich dabei vorzugsweise von einem ersten zu einem zweiten elektrischen Kontaktpunkt. Die beiden elektrischen Kontakte sind vorzugsweise im Bereich des fest eingespannten Endes des Aktuators angeordnet. Vorteilhafterweise ist die Stromleitung u-förmig ausgebildet. Alternativ oder zusätzlich weist die Stromleitung einen ersten Längsteil auf. Der erste Längsteil erstreckt sich vom ersten elektrischen Kontakt ausgehend in Kragarmlängsrichtung in den Kragarm hinein. Alternativ oder zusätzlich weist die Stromleitung einen Querteil auf. Der Querteil erstreckt sich in Kragarmquerrichtung. Alternativ oder zusätzlich weist die Stromleitung einen zweiten Längsteil auf. Der zweite Längsteil erstreckt sich vom Querteil ausgehend in Kragarmlängsrichtung aus dem Kragarm hinaus zum zweiten elektrischen Kontakt. Auf diese Weise kann eine äußerst empfindliche Brückenschaltung zur genauen Bestimmung von Widerständen bzw. Widerstandsänderungen ausgebildet werden. Aus dem ermittelten Wert können sodann Rückschlüsse auf die Auslenkung der Membran gezogen werden, sodass diese von der Steuereinheit geregelt ansteuerbar ist.

In einer vorteilhaften Weiterbildung ist die Stromleitung in einer Tragschicht des piezoelektrischen Aktuators ausgebildet. Die Ausbildung der Stromleitung in der Tragschicht erfolgt durch ein Ionenimplantations-Verfahren. Die Tragschicht ist vorzugsweise metallisch ausgebildet. Die Realisierung einer leitfähigen Schicht kann dadurch einfach und kostengünstig erfolgen. Die Aktuator-Performance wird zudem positiv beeinflusst, da durch die Verwendung des piezoresistiven Positionssensors weiterhin eine große Aktuatorschicht zur Anregung der Membran ausgebildet ist.

Vorteilhafterweise umfasst der piezoresistive Positionssensor mehrere, insbesondere vier, Stromleitungen. Die Stromleitungen weisen zueinander unterschiedliche elektrische Widerstände auf.

Vorteilhaft ist es in die Steuereinheit als Wheatstone'sche Messbrücke ausgebildet ist. Um eine möglichst feine Auflösung der Messergebnisse zu erzielen, können alternativ oder zusätzlich die Stromleitungen ebenso als Wheatstone'sche Messbrücke ausgebildet sein. Dadurch kann hohes Nutzsignal bereitgestellt werden, das keinen Hysterese-Effekt zur Folge hat. Die Qualität des MEMS-Lautsprechers ist somit weiterhin gewährleistet.

Von Vorteil ist es, wenn der kapazitive Positionssensor zumindest eine Aussparung und einen darin in z-Richtung bewegbar angeordneten Fortsatz umfasst. Dabei ist eines der beiden Elemente am, in z-Richtung auslenkbaren, Kragarm und das andere an einem ortsfesten Rahmen angeordnet. Die Aussparung bildet dabei einen kapazitiven Abstandssensor und der Fortsatz eine dazu bewegliche Gegenfläche, die am Kragarm angeordnet ist. Durch die Auslenkung des Kragarmes vergrößert sich der Abstand des Fortsatzes zum Abstandssensor, so dass auf diese Weise die Kapazität bestimmt werden kann. Aus der ermittelten Kapazität kann in einfacher Art und Weise auch die von der Auslenkung der Aktuatorstruktur abhängige Position der Membran bestimmt werden.

Um den kapazitiven Positionssensor kostengünstig zu realisieren, ist es vorteilhaft, wenn zumindest eine der beiden Innenflächen der Aussparung als Messelektrode ausgebildet ist. Alternativ oder zusätzlich ist der Fortsatz als Dielektrikum oder zweite Messelektrode ausgebildet, so dass in Wechselwirkung mit der ersten Messelektrode ein kapazitiver Sensor ausgebildet ist. Durch die Änderung des Plattenabstandes kann die Kapazitätsänderung ermittelt und ausgewertet werden.

Von Vorteil ist es, wenn die Steuereinheit derart ausgebildet ist, dass der als piezoelektrischer Aktuator ausgebildete Kragarm entweder als Aktuator oder als Positionssensor nutzbar ist. Der Kragarm ist dabei zu einem Zeitpunkt als Aktuator und zu einem anderen Zeitpunkt als Positionssensor nutzbar. Der MEMS-Lautsprecher kann somit kostengünstig an unterschiedliche Gegebenheiten angepasst werden.

Vorteilhafterweise ist der Aktuator mit der in z-Richtung bewegbaren Hubstruktur des MEMS-Lautsprechers verbunden. Die Verbindung erfolgt dabei insbesondere über ein flexibles Verbindungselement. Alternativ oder zusätzlich ist der Positionssensor ebenso mit der Hubstruktur des MEMS-Lautsprechers verbunden. Von Vorteil ist es, wenn die Membran an einer in z-Richtung zeigenden Stirnseite der Hubstruktur befestigt ist. Alternativ oder zusätzlich greifen der Aktuator und/oder der Positionssensor seitlich an der Hubstruktur an. Dies erfolgt insbesondere mittelbar über das jeweilige Verbindungselement. Der piezoelektrische Aktuator ist ausgebildet, um eine Hubbewegung der Hubstruktur hervorzurufen, um die Membran auszulenken. Durch die mittelbare Verbindung des Positionssensors mit der Hubstruktur können zuverlässig Rückschlüsse auf die Position der Membran gezogen werden. Zudem ermöglicht es diese Ausbildung gleichzeitig hohe Kräfte und Auslenkungen über die Hubstruktur auf die Membran zu übertragen.

Von Vorteil ist es, wenn mehrere Aktuatoren und/oder Positionssensoren symmetrisch zum Schwerpunkt der Hubstruktur angeordnet sind. Dies erfolgt insbesondere paarweise und/oder gegenüberliegend. Einer ungewollten Verkippung des Hubkörpers aufgrund eines asymmetrischen Antriebs kann dadurch vorgebeugt werden.

Weitere Vorteile der Erfindung sind in den nachfolgenden Ausführungsbeispielen beschrieben. Es zeigt:
- **Figur 1**: eine perspektivische Schnittansicht eines MEMSLautsprechers, gemäß einem Ausführungsbeispiel der vorliegenden Erfindung,
- **Figur 2**: eine schematische Draufsicht eines Ausführungsbeispiels eines piezoelektrischen Aktuators mit integriertem Positionssensor,
- **Figur 3**: eine schematische Draufsicht eines zweiten Ausführungsbeispiels eines piezoelektrischen Aktuators mit integriertem Positionssensor,
- **Figur 4**: eine schematische Seitenansicht des zweiten Ausführungsbeispiels eines piezoelektrischen Aktuators mit integriertem Positionssensor,
- **Figur 5**: eine schematische Draufsicht eines dritten Ausführungsbeispiels eines piezoelektrischen Aktuators mit piezoresistiven Positionssensor,
- **Figur 6**: eine schematische Draufsicht eines vierten Ausführungsbeispiels eines piezoelektrischen Aktuators mit kapazitivem Positionssensor,
- **Figur 7**: eine Detailansicht des kapazitiven Positionssensors.

Bei der nachfolgenden Figurenbeschreibung werden, um die Beziehungen zwischen den verschiedenen Elementen zu definieren, bezugnehmend auf die jeweils in den Figuren dargestellte Lage der Objekte relative Begriffe, wie beispielsweise oberhalb, unterhalb, oben, unten, drüber, drunter, links, rechts, vertikal und horizontal, verwendet. Es versteht sich von selbst, dass sich diese Begrifflichkeiten bei einer Abweichung von der in den Figuren dargestellten Lage der Vorrichtungen und/oder Elemente verändern können. Demnach würde beispielsweise bei einer in Bezug auf die Figuren dargestellten invertierten Orientierung der Vorrichtungen und/oder Elemente ein in der nachfolgenden Figurenbeschreibung als oberhalb spezifiziertes Merkmal nunmehr unterhalb angeordnet sein. Die verwendeten Relativbegriffe dienen somit lediglich zur einfacheren Beschreibung der relativen Beziehungen zwischen den einzelnen im nachfolgenden beschriebenen Vorrichtungen und/oder Elemente.

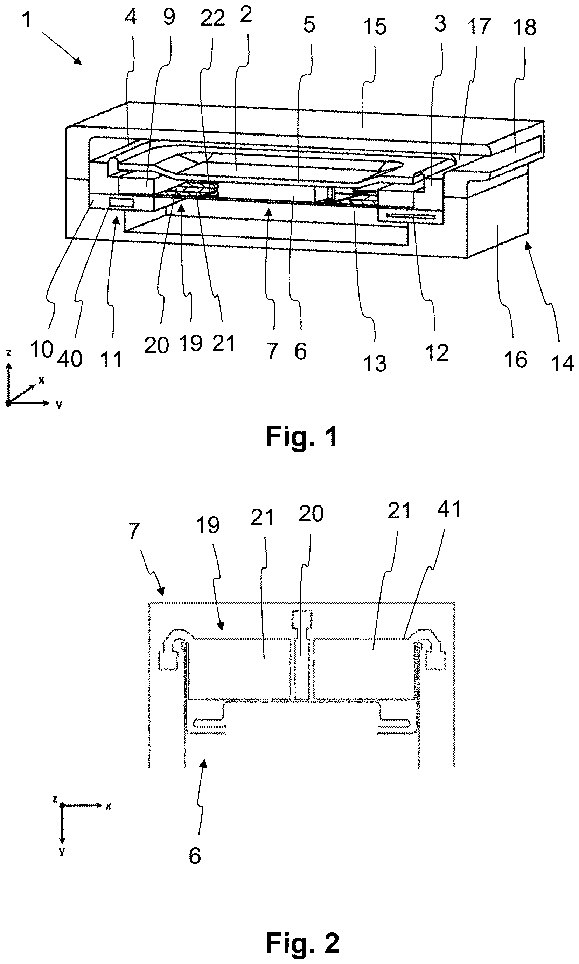

Die Figur 1 zeigt ein erstes Ausführungsbeispiel eines MEMS-Lautsprechers 1. Der MEMS-Lautsprecher 1 ist zum Erzeugen von Schallwellen im hörbaren Wellenlängenspektrum ausgebildet. Hierzu besitzt der MEMS-Lautsprecher 1 eine Membran 2 und einen Membranträger 3. Die Membran 2 ist in ihrem Randbereich 4 mit dem Membranträger 3 verbunden und vermag gegenüber dem Membranträger 3 entlang einer z-Achse zu schwingen. Die z-Achse verläuft dabei im Wesentlichen senkrecht zu der Membran 2. An der Unterseite der Membran 2 ist ein Verstärkungselement 5 angeordnet.

Der MEMS-Lautsprecher 1 weist neben der Membran 2 eine Hubstruktur 6, die mit der Membran 2 gekoppelt ist, und zumindest einen piezoelektrischen Aktuator 7 auf. Der Membranträger 3 ist an einem Trägersubstrat 9 des piezoelektrischen Aktuators 7 angeordnet. Dieser piezoelektrische Aktuator 7 ist unterhalb der Membran 2 und/oder im Wesentlichen parallel zu dieser angeordnet. Der piezoelektrische Aktuator 7 ist ausgebildet, um eine uni- oder bidirektionale Hubbewegung der Hubstruktur 6 hervorzurufen, um die Membran 2 auszulenken. Er wirkt mit der Membran 2 zusammen, um elektrische Signale in akustisch wahrnehmbare Schallwellen zu wandeln. Der piezoelektrische Aktuator 7 ist an einer der Membran 2 abgewandten Seite des Trägersubstrates 9 angeordnet.

Des Weiteren umfasst der MEMS-Lautsprecher 1 eine Leiterplatte 10. In die Leiterplatte 10 ist eine elektronische Steuereinheit 11, insbesondere ein ASIC, vollständig eingebettet. Zusätzlich zu der Steuereinheit 11 können auch weitere passive Komponenten 12, wie elektrische Widerstände und/oder E/A-Kontakte, in die Leiterplatte 10 eingebettet und/oder an dieser angeordnet sein. Der MEMS-Lautsprecher 1 und insbesondere der piezoelektrische Aktuator 7 ist mit in den Figuren nicht weiter dargestellten elektrischen Kontakten mit der Steuereinheit 11 verbunden. Der MEMS-Lautsprecher 1 kann somit über die Steuereinheit 11 angesteuert bzw. betrieben werden, so dass durch den piezoelektrischen Aktuator 7 die Membran 2 zur Erzeugung von Schallenergie gegenüber dem Membranträger 3 in Schwingung versetzt wird. Der piezoelektrische Aktuator 7 ist dabei als Kragarm 13 ausgebildet.

Der MEMS-Lautsprecher 1 ist in einem Gehäuse 14 angeordnet. Das Gehäuse 14 umfasst einen oberen Gehäuseteil 15 und einen unteren Gehäuseteil 16. Der obere Gehäuseteil 15 bildet einen Schalleitkanal 17 mit einer akustischen Ein-/Austrittsöffnung 18 aus, die seitlich an einer Außenfläche des MEMS-Lautsprechers 1 angeordnet ist. Das Gehäuse 14 bietet insbesondere einen zusätzlichen Schutz für die Membran 2, da es diese gegenüber der Umgebung abdeckt.

Der MEMS-Lautsprecher 1 weist zumindest einen Positionssensor 19 auf. Der Positionssensor 19 ist ausgebildet, um der elektronischen Steuereinheit 11 ein von der Membranauslenkung abhängiges Sensorsignal bereitzustellen. Die Steuereinheit 11 ist ausgebildet, um den Aktuator 7 basierend auf dem Sensorsignal geregelt anzusteuern. Der Positionssensor 19 kann zu diesem Zweck ein piezoelektrischer, ein piezoresistiver und/oder ein kapazitiver Sensor sein. Der Positionssensor 19 ist zumindest teilweise in dem Aktuator 7, insbesondere dem Kragarm 13 integriert.

Im dargestellten Ausführungsbeispiel werden der Positionssensor 19 und der piezoelektrische Aktuator 7 durch eine gemeinsame piezoelektrische Schicht 41 gebildet. Die piezoelektrische Schicht ist aus Blei-Zirkonat-Titanat (PZT) ausgebildet. Zumindest ein Bereich ist ein Sensorbereich 20, durch welchen zwei Aktuatorbereiche 21 voneinander beabstandet angeordnet sind. Die Sensor- und Aktuatorbereiche 20, 21 sind elektrisch voneinander isoliert. Da sich die Anforderungen für Sensorik und Aktuatorik unterscheiden können, ist auch eine Kombination verschiedener piezoelektrischer Materialien mit unterschiedlichen Eigenschaften denkbar. Dabei kann der Sensorbereich 20 aus PZT und der Aktuatorbereich 21 aus Aluminiumnitrid (AIN) ausgebildet sein.

Der Sensorbereich 20 ist zwischen den beiden Aktuatorbereichen 21 angeordnet und erstreckt sich symmetrisch in Kramarmlängsrichtung. Die Aktuatorbereiche 21 sind durch den Sensorbereich 20 vollständig voneinander getrennt. Der Sensorbereich 20 und der Aktuatorbereich 21 weisen in Kragarmlängsrichtung die gleiche Länge auf. Die beiden Aktuatorbereiche 21 sind flächenmäßig größer als der Sensorbereich 20.

Bei einer Auslenkung der Membran 2 über den Aktuator 7 wird nun deren Position bzw. Auslenkung in z-Richtung mittels des Positionssensors 19 erfasst. Dabei wird die über den piezoelektrischen Effekt generierte Spannung, welche näherungsweise proportional zur Auslenkung der Hubstruktur 6 ist, über die Aktuator-Elektroden abgegriffen und entsprechend ausgewertet. Die Steuereinheit 11 bestimmt anhand dieses erfassten Eingangssignals die Ist-Position bzw. Ist-Auslenkung der Membran 2. Dabei werden die elastischen Schwingungseigenschaften eines Verbindungselements 22 berücksichtigt. Das Verbindungselement 22 verbindet ein freies Ende des Positionssensors 19 mit der Hubstruktur 6. In Abhängigkeit dieser erfassten Ist-Position der Membran 2 bestimmt die Steuereinheit 11 eine gewünschte Soll-Position der Membran und/oder ein davon abhängiges elektronisches Ausgangssignal. Das Ausgangssignal wird an den Aktuator 7 übermittelt, der die Membran 2 entsprechend auslenkt. Während und/oder am Ende der Auslenkbewegung wird über den Positionssensor 19 erneut die tatsächliche Ist-Position der Membran 2 erfasst und gegebenenfalls gemäß der vorangegangenen Beschreibung erneut an die Umgebungsbedingungen angepasst.

Figur 2 zeigt eine schematische Draufsicht eines Ausführungsbeispiels eines piezoelektrischen Aktuators 7 mit integriertem Positionssensor 19. Der piezoelektrische Aktuator 7 weist dabei zwei Aktuatorbereiche 21 auf, die durch den Sensorbereich 20 voneinander getrennt werden. Beide Bereiche 20, 21 sind aus PZT ausgebildet. Es sind jedoch auch andere piezoelektrische Materialien denkbar. Dabei wäre es auch denkbar, dass ein großer Teil für die Aktorik und nur ein kleiner Bereich für den Sensor verwendet wird. Der Sensorbereich 20 ist dabei elektrisch von den Aktuatorbereichen 21 isoliert. Um einer ungewollten Verkippung der Hubstruktur 6 aufgrund eines asymmetrischen Antriebs vorzubeugen, sollten die Aktuator- und Sensorbereiche 21, 20 jeweils paarweise gegenüber angeordnet sein.

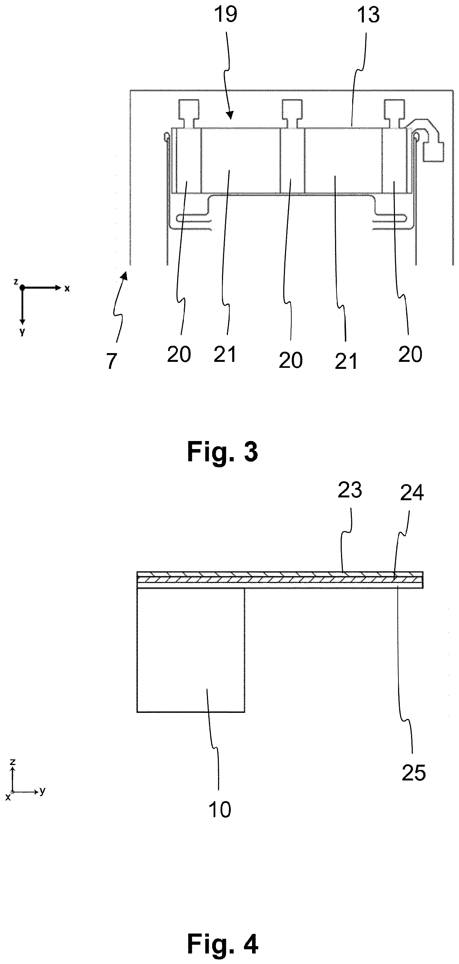

Die Figuren 3 und 4 zeigen jeweils eine schematische Ansicht eines weiteren zweiten Ausführungsbeispiels des piezoelektrischen Aktuators 7 mit Positionssensor 19. Der piezoelektrische Positionssensor 19 wird dabei durch eine erste piezoelektrische Schicht 23, insbesondere aus AIN, ausgebildet. Der piezoelektrische Aktuator 7 wird durch eine zweite piezoelektrische Schicht 24, insbesondere aus PZT, ausgebildet. Die beiden Schichten sind voneinander elektrisch isoliert und in Bezug zur z-Achse übereinander angeordnet. Die erste piezoelektrische Schicht 23 ist in mehrere Sensorbereiche 20 unterteilt. Die Sensorbereiche 20 sind voneinander getrennt und/oder elektrisch isoliert. Im dargestellten Ausführungsbeispiel sind drei Sensorbereiche 20 ausgebildet, die in Kragarmquerrichtung voneinander beabstandet angeordnet sind. Dies erfolgt insbesondere äquidistant. Die zweite piezoelektrische Schicht 24 weist einen sich über den Kragarm 13 erstreckenden Aktuatorbereich 21 auf. Dieser Aktuatorbereich 21 erstreckt sich zumindest in einer Draufsicht vollflächig über den Kragarm 13. Die beiden Aktuatorbereiche 21 weisen in Kragarmlängsrichtung die gleiche Länge auf. Es ist jedoch auch denkbar, dass sich der Sensorbereich 20 nicht über die gesamte Kragarmlängsrichtung erstreckt, sondern nur über einen Teil davon. In diesem Fall würde die Differenz zur Kragarmlänge durch einen weiteren nicht dargestellten Aktuatorbereich ausgebildet werden.

Wie in Figur 4 dargestellt, bilden beiden piezoelektrischen Schichten 23, 24 einen Stapel aus, der von einer Tragschicht 25 getragen wird. Die Tragschicht 25 ist mit der Leiterplatte 10 verbunden. Im dargestellten Ausführungsbeispiel ist die erste piezoelektrische Schicht 23, welche den Positionssensor 19 ausbildet über der zweiten piezoelektrischen Schicht 24, insbesondere dem Aktuator 7, angeordnet. Die erste piezoelektrische Schicht 23 könnte jedoch auch unter dem piezoelektrischen Aktuator 7 angeordnet sein.

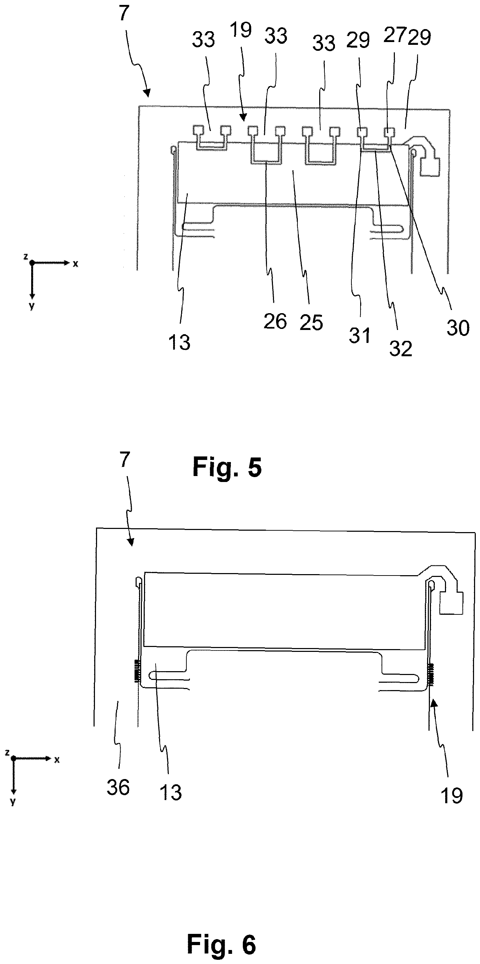

Figur 5 zeigt eine schematische Draufsicht eines dritten Ausführungsbeispiels eines piezoelektrischen Aktuators 7 mit integriertem Positionssensor 19. Der Positionssensor 19 ist dabei piezoresistiv, insbesondere durch eine Stromleitung 26, ausgebildet. Die Stromleitung 26 wird durch ein lonenimplantationsverfahren in der Tragschicht 25 des piezoelektrischen Aktuators 7 ausgebildet. Die Stromleitung 26 erstreckt sich von einem ersten elektrischen Kontakt 27 zu einem zweiten elektrischen Kontakt 28. Die beiden elektrischen Kontakte 27, 28 sind vorzugsweise im Bereich des fest eingespannten Endes 29 des Aktuators 7 angeordnet. Die Stromleitung 26 ist u-förmig ausgebildet und weist einen ersten Längsteil 30 und einen zweiten Längsteil 31 auf. Der erste Längsteil 30 erstreckt sich vom ersten elektrischen Kontakt 27 ausgehend in Kragarmlängsrichtung in den Kragarm 13 hinein. Der zweite Längsteil 31 erstreckt sich von einem Querteil 32 ausgehend in Kragarmlängsrichtung aus dem Kragarm 13 hinaus zum zweiten elektrischen Kontakt 28, wobei sich das Querteil 32 in Kragarmquerrichtung erstreckt. Auf die soeben beschriebene Weise werden vier elektrische Widerstände 33 ausgebildet. Die Widerstände 33 sind zueinander unterschiedlich und derart mit der Steuereinheit 11 verbunden, dass eine Wheatstonesche Messbrücke ausgebildet wird.

Die Stromleitungen 26, insbesondere die Widerstände 33, reagieren dabei auf Verformungen, die infolge der Druckveränderung, welche aus der Membranauslenkung resultiert, entstehen. Die Widerstände 33 reagieren darauf mit einer Widerstandänderung, die von der Steuereinheit 11 erfasst und ausgewertet wird.

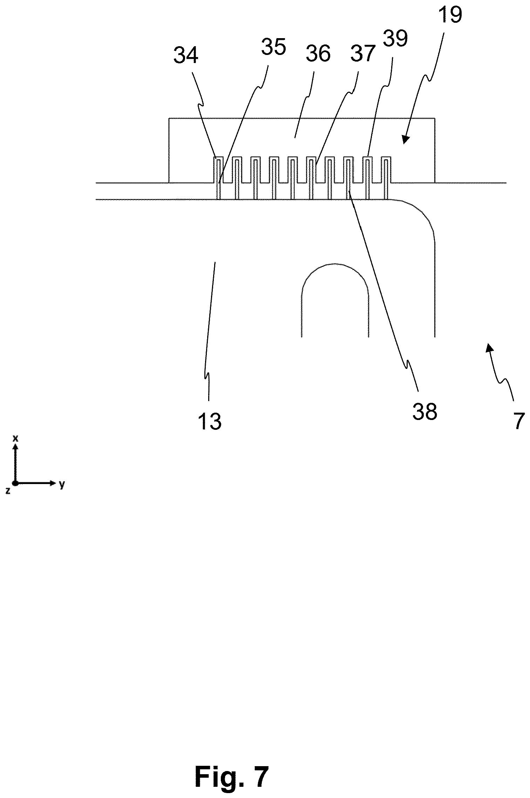

Die Figuren 6 und 7 zeigen eine schematische Draufsicht und eine Detailansicht eines vierten Ausführungsbeispiels eines piezoelektrischen Aktuators 7 mit kapazitivem Positionssensor 19. Der kapazitive Positionssensor 19 weist mehrere Aussparungen 34 auf, in welchen jeweils ein Fortsatz 35 angeordnet ist. Jeder Fortsatz 35 ist in z-Richtung bewegbar. Im dargestellten Ausführungsbeispiel sind die Aussparungen 34 an einem Rahmen 36 und die Fortsätze 35 am Kragarm 13 angeordnet. Der Kragarm 13 ist ebenso in z-Richtung auslenkbar. Der Rahmen 36 hingegen ist ortsfest und wird vorzugsweise durch das Trägersubstrat 9 ausgebildet. Es ist jedoch auch denkbar, dass die Aussparungen 34 im Kragarm 13 und die Fortsätze 35 am Rahmen 36 ausgebildet werden. Die Aussparung 34 weist zwei Innenflächen 37 auf, wobei zumindest eine der Innenflächen 37 als erste Messelektrode 38 ausgebildet ist. Der Fortsatz 35 ist entweder als zweite Messelektrode 39 oder als Dielektrikum ausgebildet. Auf diese Weise wird ein elektrischer Kondensator ausgebildet.

Infolge einer Anregung der Membran 2 durch den Aktuator 7, werden die Fortsätze 35 am Kragarm 13 ebenso ausgelenkt. Der Abstand der einzelnen Fortsätze 35 zur jeweilig korrespondierenden Aussparung 34 vergrößert sich daraufhin. Folglich vergrößert sich auch der Abstand der beiden Messelektroden 38, 39 bzw. der Abstand der ersten Messelektrode 38 zum Dielektrikum. Da die Kapazität durch eben diesen Abstand bestimmt wird, erfasst die Steuereinheit 11 infolge der Auslenkung eine Kapazitätsänderung. In Abhängigkeit dieses kapazitiven Sensorsignals kann der Aktuator 7 geregelt angesteuert werden, um die Membran 2 an die äußeren Einflüsse angepasst anzuregen (vgl. hierzu auch Figur 1).

### Bezugszeichenliste

- 1: MEMS-Lautsprecher
- 2: Membran
- 3: Membranträger
- 4: Randbereich
- 5: Verstärkungselement
- 6: Hubstruktur
- 7: Aktuator
- 9: Trägersubstrat
- 10: Leiterplatte
- 11: Steuereinheit
- 12: passive Zusatzkomponenten
- 13: Kragarm
- 14: Gehäuse
- 15: oberer Gehäuseteil
- 16: unterer Gehäuseteil
- 17: Schalleitkanal
- 18: akustische Ein-/Austrittsöffnung
- 19: Positionssensor
- 20: Sensorbereich
- 21: Aktuatorbereich
- 22: Verbindungselement
- 23: erste piezoelektrische Schicht
- 24: zweite piezoelektrische Schicht
- 25: Tragschicht
- 26: Stromleitung
- 27: erster elektrischer Kontakt
- 28: zweiter elektrischer Kontakt
- 29: fest eingespanntes Ende
- 30: erster Längsteil
- 31: zweiter Längsteil
- 32: Querteil
- 33: Widerstände
- 34: Aussparung
- 35: Fortsatz
- 36: Rahmen
- 37: Innenfläche
- 38: erste Messelektrode
- 39: zweite Messelektrode
- 40: ASIC
- 41: gemeinsame piezoelektrische Schicht

## Patentansprüche

1. MEMS-Lautsprecher (1) zum Erzeugen von Schallwellen im hörbaren Wellenlängenspektrum
mit einer Leiterplatte (10),
einer gegenüber der Leiterplatte (10) entlang einer z-Achse auslenkbaren Membran (2),
zumindest einem piezoelektrischen Aktuator (7) zum Auslenken der Membran (2),
einer vollständig in der Leiterplatte (10) eingebetteten elektronischen Steuereinheit (11) zum Ansteuern des Aktuators (7) und
zumindest einem Positionssensor (19), mittels dem der Steuereinheit (11) ein von der Membranauslenkung abhängiges Sensorsignal bereitstellbar ist,
wobei die Steuereinheit (11) ausgebildet ist, um den Aktuator (7) basierend auf dem Sensorsignal geregelt anzusteuern,
**dadurch gekennzeichnet,**
**dass** der Aktuator (7) und der Positionssensor (19) über eine entlang der z-Achse bewegbare Hubstruktur (6) des MEMS-Lautsprechers mit der Membran (2) verbunden sind und
**dass** der Aktuator (7) als Kragarm (13) ausgebildet ist und dass der Positionssensor (19) zumindest teilweise in den Kragarm (13) integriert ist.

2. MEMS-Lautsprecher nach dem vorherigen Anspruch, **dadurch gekennzeichnet, dass** der Positionssensor (19) ein piezoelektrischer Sensor ist.

3. MEMS-Lautsprecher nach dem vorherigen Anspruch 2, **dadurch gekennzeichnet, dass** der piezoelektrische Positionssensor (19) und der piezoelektrische Aktuator (7) durch eine gemeinsame piezoelektrische Schicht (41) ausgebildet sind.

4. MEMS-Lautsprecher nach dem vorherigen Anspruch 3, **dadurch gekennzeichnet, dass** die gemeinsame piezoelektrische Schicht (41) zumindest einen Sensorbereich (20) und zumindest einen, insbesondere von diesem elektrisch isolierten und/oder zu diesem flächenmäßig größeren, Aktuatorbereich (21) aufweist.

5. MEMS-Lautsprecher nach dem vorherigen Anspruch 2, **dadurch gekennzeichnet, dass** der piezoelektrische Positionssensor (19) durch eine erste piezoelektrische Schicht (23) und der piezoelektrische Aktuator (7) durch eine zweite piezoelektrische Schicht (24) ausgebildet sind, die vorzugsweise voneinander elektrisch isoliert sind und/oder in Bezug zur z-Achse übereinander angeordnet sind.

6. MEMS-Lautsprecher nach dem vorherigen Anspruch 5, **dadurch gekennzeichnet, dass** die erste piezoelektrische Schicht (23) in mehrere, insbesondere voneinander getrennte und/oder elektrisch isolierte, Sensorbereiche (20) unterteilt ist und/oder
die zweite piezoelektrische Schicht (24) einen einzigen Aktuatorbereich (21) aufweist.

7. MEMS-Lautsprecher nach dem vorherigen Anspruch 1, **dadurch gekennzeichnet, dass** der Positionssensor (19) ein piezoresistiver Sensor ist.

8. MEMS-Lautsprecher nach dem vorherigen Anspruch 7, **dadurch gekennzeichnet, dass** der piezoresistive Positionssensor (19) durch zumindest eine Stromleitung (26) ausgebildet ist, die sich vorzugsweise von einem ersten zu einem zweiten elektrischen Kontakt (27, 28) erstreckt, wobei die beiden elektrischen Kontakte (27, 28) vorzugsweise im Bereich des fest eingespannten Endes (29) des Aktuators (7) angeordnet sind.

9. MEMS-Lautsprecher nach dem vorherigen Anspruch 8, **dadurch gekennzeichnet, dass** die Stromleitung (26) in einer, vorzugsweise metallischen, Tragschicht (25) des piezoelektrischen Aktuators (7) ausgebildet ist.

10. MEMS-Lautsprecher nach einem oder mehreren der vorherigen Ansprüche 8 bis 9, **dadurch gekennzeichnet, dass** der piezoresistive Positionssensor (19) mehrere, insbesondere vier, Stromleitungen (26) umfasst, die zueinander unterschiedliche elektrische Widerstände (33) aufweisen und/oder
dass die Steuereinheit (11) und/oder die Stromleitungen (26) als Wheatstonesche Messbrücke ausgebildet sind.

11. MEMS-Lautsprecher nach dem vorherigen Anspruch 1, **dadurch gekennzeichnet, dass** der Positionssensor (19) ein kapazitiver Sensor ist.

12. MEMS-Lautsprecher nach dem vorherigen Anspruch 11, **dadurch gekennzeichnet, dass** der kapazitive Positionssensor (19) zumindest eine Aussparung (34) und einen darin in z-Richtung bewegbar angeordneten Fortsatz (35) umfasst, wobei eines der beiden Elemente am in z-Richtung auslenkbaren Kragarm (13) und das andere an einem ortsfesten Rahmen (36) angeordnet ist.

13. MEMS-Lautsprecher nach dem vorherigen Anspruch 12, **dadurch gekennzeichnet, dass** zumindest eine der beiden Innenflächen (37) der Aussparung (34) als Messelektrode (38) und/oder der Fortsatz (35) als Dielektrikum oder zweite Messelektrode (39) ausgebildet sind.

14. MEMS-Lautsprecher nach einem oder mehreren der vorherigen Ansprüche, **dadurch gekennzeichnet, dass** der Aktuator (7) und/oder der Positionssensor (19) über zumindest ein, insbesondere flexibles, Verbindungselement (22) mit der in z-Richtung bewegbaren Hubstruktur (6) des MEMS-Lautsprechers (1) verbunden sind.

## Claims

1. A MEMS loudspeaker (1) for generating sound waves within the audible wavelength spectrum
with a circuit board (10),
a membrane (2) that can be deflected along a z-axis relative to the circuit board (10),
at least one piezoelectric actuator (7) to deflect the membrane (2),
an electronic control unit (11) fully embedded in the circuit board (10) for controlling the actuators (7) and
at least one position sensor (19), with which the control unit (11) can be provided with a sensor signal dependent on the membrane deflection,
wherein the control unit (11) is executed to control the actuator (7) in a regulated way based on the sensor signal
**characterized in that**
the actuator (7) and the position sensor (19), are connected to the membrane 2 via a stroke structure (6) of the MEMS loudspeaker movable in the z-axis and
that the actuator (7) is executed as cantilever arm (13) and that the position sensor (19) is at least partially integrated into the cantilever arm (13).

2. A MEMS loudspeaker according to the preceding claim, **characterized in that** the position sensor (19) is a piezoelectric sensor.

3. A MEMS loudspeaker according to the preceding claim 2, **characterized in that** the piezoelectric position sensor (19) and the piezoelectric actuator (7) are formed by a joint piezoelectric layer (41).

4. A MEMS loudspeaker according to the preceding claim 3, **characterized in that** the joint piezoelectric layer (41) has at least one sensor area (20) and at least one actuator area (21), particularly electrically insulated therefrom and/or with a larger surface compared to it.

5. A MEMS loudspeaker according to the preceding claim 2, **characterized in that** the piezoelectric position sensor (19) is formed by a first piezoelectric layer (23) and the piezoelectric actuator (7) by a second piezoelectric layer (24), that are preferably electrically insulated from each other and/or arranged on top of one another with regard to the z-axis.

6. A MEMS loudspeaker according to the preceding claim 5, **characterized in that** the first piezoelectric layer (23) is subdivided into several sensor areas (20), particularly separated from one another and/or electrically insulated and/or
the second piezoelectric layer (24) has one single actuator area (21).

7. A MEMS loudspeaker according to the preceding claim 1, **characterized in that** the position sensor (19) is a piezoresistive sensor.

8. A MEMS loudspeaker according to the preceding claim 7, **characterized in that** the piezoresistive position sensor (19) is formed by at least one power line (26) that extends preferably from a first to a second electrical contact (27, 28), wherein the two electrical contacts (27, 28) are arranged preferably in the area of the firmly clamped end (29) of the actuator (7).

9. A MEMS loudspeaker according to the preceding claim 8, **characterized in that** the power line (26) is formed within a, preferably metallic, base layer (25) of the piezoelectric actuator (7).

10. A MEMS loudspeaker according to one or several of the preceding claims 8 to 9, **characterized in that** the piezoresistive position sensor (19) encompasses several, particularly four, power lines (26) that have electrical resistances (33) that differ from one another and/or
that the control unit (11) and/or the power lines (26) are executed as a Wheatstone measuring bridge.

11. A MEMS loudspeaker according to the preceding claim 1, **characterized in that** the position sensor (19) is a capacitive sensor.

12. A MEMS loudspeaker according to the preceding claim 11, **characterized in that** the capacitive position sensor (19) encompasses at least one recess (34) and an extension (35) movable therein in z-direction, wherein one of the two elements is arranged on the cantilever arm (13) that can be deflected in z-direction, and the other one on a stationary frame (36).

13. A MEMS loudspeaker according to the preceding claim 12, **characterized in that** at least one of the two inner surfaces (37) of the recess (34) is executed as measuring electrode (38) and/or the extension (35) as dielectric or second measuring electrode (39).

14. A MEMS loudspeaker according to one or several of the preceding claims, **characterized in that** the actuator (7) and/or the position sensor (19) are connected to the stroke structure (6) of the MEMS loudspeaker (1), movable in z-direction, through at least one, particularly flexible, connecting element (22).

## Revendications

1. Haut-parleur MEMS (1) destiné à générer des ondes sonores dans le spectre des longueurs d'onde audibles
comprenant une carte à circuit imprimé (10),
une membrane (2) pouvant être déviée par rapport à la carte à circuit imprimé (10) le long d'un axe Z,
au moins un actionneur piézoélectrique (7) destiné à faire dévier la membrane (2),
une unité de commande électronique (11), entièrement incorporée dans la carte à circuit imprimé (10) et servant à commander l'actionneur (7) et
au moins un capteur de position (19), au moyen duquel un signal de capteur dépendant de la déviation de la membrane peut être fourni à l'unité de commande (11),
l'unité de commande (11) étant configurée pour commander l'actionneur (7) de manière régulée sur la base du signal de capteur,
**caractérisé en ce**
**que** l'actionneur (7) et le capteur de position (19) sont reliés à la membrane (2) par le biais d'une structure d'excursion (6), mobile le long de l'axe Z, du haut-parleur MEMS, et
**que** l'actionneur (7) est réalisé sous la forme d'un bras en porte-à-faux (13) et que le capteur de position (19) est au moins partiellement intégré dans le bras en porte-à-faux (13).

2. Haut-parleur MEMS selon la revendication précédente, **caractérisé en ce que** le capteur de position (19) est un capteur piézoélectrique.

3. Haut-parleur MEMS selon la revendication 2 précédente, **caractérisé en ce que** le capteur de position piézoélectrique (19) et l'actionneur piézoélectrique (7) sont formés par une couche piézoélectrique (41) commune.

4. Haut-parleur MEMS selon la revendication 3 précédente, **caractérisé en ce que** la couche piézoélectrique (41) commune possède au moins une zone de capteur (20) et au moins une zone d'actionneur (21), notamment isolée électriquement de celle-ci et/ou dont la surface est plus grande que celle-ci.

5. Haut-parleur MEMS selon la revendication 2 précédente, **caractérisé en ce que** le capteur de position (19) piézoélectrique est formé par une première couche piézoélectrique (23) et l'actionneur piézoélectrique (7) par une deuxième couche piézoélectrique (24), lesquelles sont de préférence isolées électriquement l'une de l'autre et/ou sont disposées l'une au-dessus de l'autre en référence à l'axe Z.

6. Haut-parleur MEMS selon la revendication 5 précédente, **caractérisé en ce que** la première couche piézoélectrique (23) est subdivisée en plusieurs zones de capteur (20), de préférence séparées et/ou isolées électriquement les unes des autres, et/ou la deuxième couche piézoélectrique (24) possède une zone d'actionneur (21) unique.

7. Haut-parleur MEMS selon la revendication 1 précédente, **caractérisé en ce que** le capteur de position (19) est un capteur piézorésistif.

8. Haut-parleur MEMS selon la revendication 7 précédente, **caractérisé en ce que** le capteur de position piézorésistif (19) est formé par au moins une ligne électrique (26) qui s'étend de préférence d'un premier à un deuxième contact électrique (27, 28), les deux contacts électriques (27, 28) étant de préférence disposés dans la zone de l'extrémité (29) serrée de manière fixe de l'actionneur (7).

9. Haut-parleur MEMS selon la revendication 8 précédente, **caractérisé en ce que** la ligne électrique (26) est formée dans une couche porteuse (25), de préférence métallique, de l'actionneur piézoélectrique (7).

10. Haut-parleur MEMS selon une ou plusieurs des revendications 8 à 9 précédentes, **caractérisé en ce que** le capteur de position piézorésistif (19) comporte plusieurs, notamment quatre lignes électriques (26), lesquelles présentent des résistances électriques (33) différentes les unes des autres, et/ou
que l'unité de commande (11) et/ou les lignes électriques (26) sont réalisées sous la forme d'un pont de mesure de Wheatstone.

11. Haut-parleur MEMS selon la revendication 1 précédente, **caractérisé en ce que** le capteur de position (19) est un capteur capacitif.

12. Haut-parleur MEMS selon la revendication 11 précédente, **caractérisé en ce que** le capteur de position capacitif (19) comporte au moins une cavité (34) et un prolongement (35) monté mobile dans la direction Z dans celle-ci, l'un des deux éléments étant disposé sur le bras en porte-à-faux (13) pouvant être dévié dans la direction Z et l'autre au niveau d'un cadre (36) en position fixe.

13. Haut-parleur MEMS selon la revendication 12 précédente, **caractérisé en ce qu'**au moins l'une des deux surfaces intérieures (37) de la cavité (34) est configurée en tant qu'électrode de mesure (38) et/ou le prolongement (35) en tant que diélectrique ou deuxième électrode de mesure (39).

14. Haut-parleur MEMS selon une ou plusieurs des revendications précédentes, **caractérisé en ce que** l'actionneur (7) et/ou le capteur de position (26) sont reliés par le biais d'au moins un élément de liaison (22), notamment flexible, à la structure d'excursion (6), mobile le long de l'axe Z, du haut-parleur MEMS (1).
